# EUROPÄISCHE PATENTANMELDUNG

(11) **EP 0 580 168 A2**
(43) Veröffentlichungstag der Anmeldung: **26.01.1994**
(21) Anmeldenummer: 93111788.1
(22) Anmeldetag: 23.07.1993
(51) Int. Cl.: G11B 20/18, H03M 13/00

(54) **Verfahren und Anordnung zur Fehlerkorrektur bei digitaler Magnetbandaufzeichnung und -wiedergabe**

(30) Priorität: 23.07.1992 DE 4224326
(71) Anmelder: GRUNDIG E.M.V. Elektro-Mechanische Versuchsanstalt Max Grundig holländ. Stiftung & Co. KG., D-90748 Fürth (DE); IR3 Video International GmbH, 90471 Nürnberg (DE)
(72) Erfinder: Geisen, Norbert, GRUNDIG E.M.V., D-90748 Fürth (DE)
(74) Vertreter: Dreykorn-Lindner, Werner, Dipl.-Ing.

(57) **Zusammenfassung**

Die Erfindung betrifft ein Verfahren und eine Anordnung zur Fehlerkorrektur bei digitaler Magnetbandaufzeichnung und -wiedergabe auf bzw. von einzelnen Spuren eines Magnetbandes nach dem Schrägspurverfahren.

Durch die immer weiter fortschreitende Datenkomprimierung im Bereich der Videoaufzeichnung und durch den Einsatz von Magnetbandgeräten mit Schrägspuraufzeichnung als Speicher werden die Anforderungen an die Fehlerkorrektur immer größer.

Aus diesem Grund wird ein Verfahren zur Fehlerkorrektur vorgeschlagen, das neben einer zweidimensionalen Korrektur in x- und in y-Richtung mittels Produktcode auch Prüfsymbole in z-Richtung hinzufügt und aufzeichnet.

## Beschreibung

Die Erfindung betrifft ein Verfahren und eine Anordnung zur Fehlerkorrektur bei digitaler Magnetbandaufzeichnung und -wiedergabe auf bzw. von einzelnen Spuren eines Magnetbandes nach dem Schrägspurverfahren.

Bei der Aufzeichnung von Videosignalen gewinnen digitale Aufzeichnungsverfahren immer mehr an Bedeutung. Die digitale Aufzeichnung bringt deutliche Vorteile bei der Bild-, aber auch der Tonqualität. Diese Qualitätsvorteile werden insbesondere beim Überspielvorgang deutlich, da die ursprüngliche Qualität weitestgehend erhalten bleibt. Weiterhin ergeben sich Vorteile bei der Bearbeitung. Trickeffekte, die bei analoger Aufzeichnung möglichst in einem Arbeitsgang ausgeführt werden mußten, um nicht merkliche Qualitätseinbußen hinnehmen zu müssen, können jetzt über mehrere Arbeitsgänge ausgeführt werden.

Einen systembedingten Vorteil erhalten die digitalen Aufzeichnungsverfahren insbesondere durch die Möglichkeit der Fehlerkorrektur, die sowohl Schutz gegen Einzelbitfehler bzw. Einzelsymbolfehler, sogenannte Random-Fehler, als auch gegen Fehlerbündel, d.h. Burstfehler, bietet. Diese Fehler können wiedergabeseitig erkannt und meist auch korrigiert werden. Nicht korrigierbare Fehler können abgeschwächt werden, indem aus benachbarten Datenworten die fehlerhaften Datenworte interpoliert werden.

Eine weit verbreitete und sehr effektive Fehlerkorrektur bietet der Produktcode. Mit diesem Code lassen sich sowohl Random-Fehler als auch Burstfehler korrigieren. Im folgenden bezieht sich die Beschreibung der Erfindung auf diesen Produktcode, wobei andere Fehlercodes, beispielsweise kaskadierte Codes, ebenfalls denkbar sind.

Die Fehlerkorrektur mittels Produktcode wird beispielsweise in dem Artikel "The SMPTE Type D-1 Digital Television Tape Recorder-Error control" von S.H. Wilkinson, SMPTE-Journal, November 1986, beschrieben.

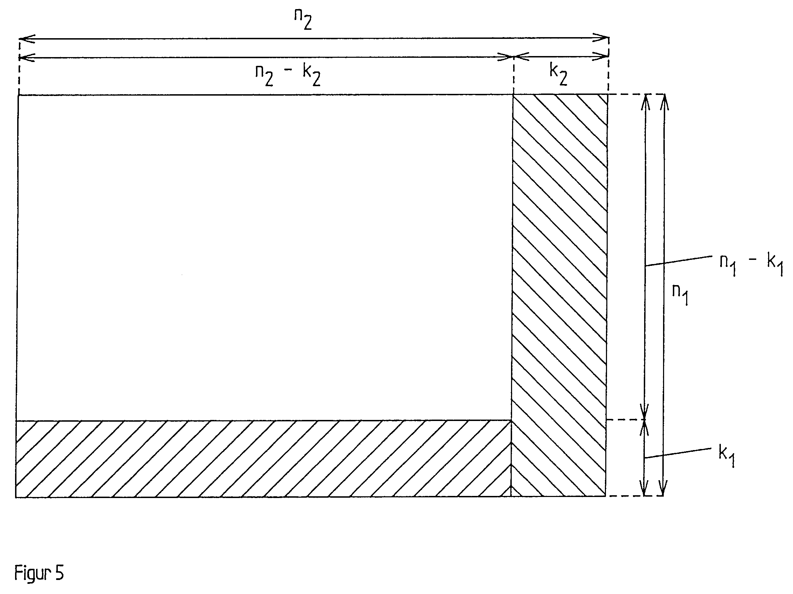

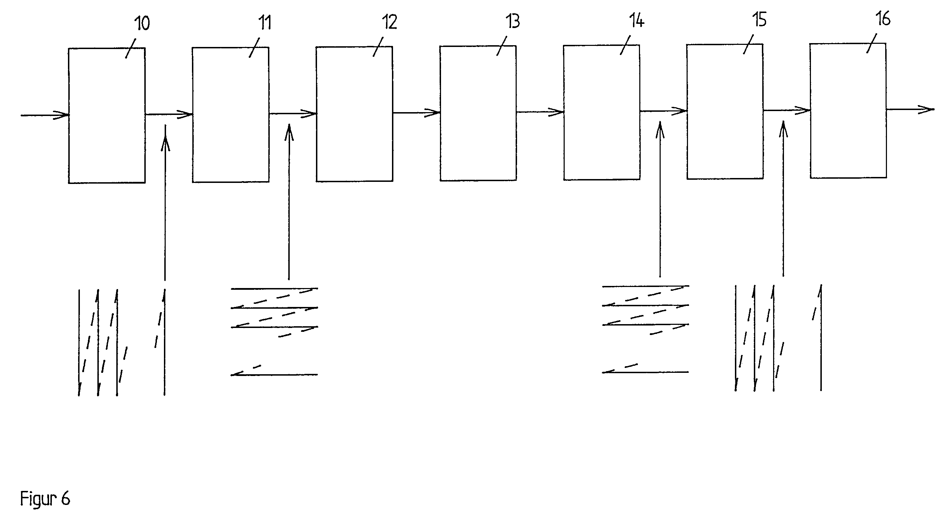

Gemäß Figur 5 werden dort die Daten blockweise angeordnet, wobei ein Block aus n₁ Zeilen mit je n₂ Symbolen und n₂ Spalten mit je n₁ Symbolen besteht und eine Zeile (n₂ - k₂) uncodierte Datensymbole und k₂ Prüfsymbole und eine Spalte (n₁ - k₁) uncodierte Datensymbole und k₁ Prüfsymbole enthält.
Die Erstellung eines solchen Blockcodes erfolgt mit einer Anordnung nach Figur 6. Am Eingang des Encoders 10 liegen zunächst digitale Video- oder Audiodaten an. Jeweils n₁-k₁ uncodierte Datensymbole werden durch k₁ Prüfsymbole, beispielsweise einem Reed Solomon-Code (R-S-Code), ergänzt und in eine Spalte des Speichers 11 geschrieben. Auf diese Weise werden (n₂ - k₂) Spalten in den Speicher 11 geschrieben. Anschließend werden die in ihm enthaltenen Datensymbole zeilenweise ausgelesen und einem Encoder 12 zugeführt. In diesem Encoder 12 wird jeder ausgelesenen Zeile ein weiterer R-S-Prüfcode, der aus k₂ Prüfsymbolen besteht, zugefügt, so daß ein zweidimensionaler Blockcode entsprechend Figur 5 entsteht. Die auf diese Weise codierten digitalen Signale werden auf ein Magnetband aufgezeichnet. Die Aufzeichnung der digitalen Daten nach dem Schrägspurverfahren erfolgt entsprechend der Struktur der Datenblöcke.
Bei der Wiedergabe werden diese Signale mit Hilfe von Decodern und Speichern in zur Aufzeichnung umgekehrter Reihenfolge wieder decodiert, so daß am Ausgang der Anordnung die Daten vorliegen, welche vor dem Codiervorgang auf der Aufzeichnungsseite am Eingang angelegen haben.

Durch die immer weiter fortschreitende Datenkomprimierung im Bereich der Videoaufzeichnung und insbesondere durch den Einsatz von Magnetbandgeräten mit Schrägspuraufzeichnung als Speicher werden die Anforderungen an die Leistungsfähigkeit der Fehlerkorrektur größer.

Es stellt sich daher die Aufgabe, eine Möglichkeit zur Fehlerkorrektur anzugeben, bei der Datenfehler sicherer und umfassender korrigiert werden können. Insbesondere sollen auch größere Burstfehler oder Fehler, die auf Grund von Mängeln der Aufzeichnungsköpfe entstehen und somit größeres Ausmaß haben, korrigiert werden können.

Diese Aufgabe wird gelöst, indem zusätzlich zur bekannten zweidimensionalen Fehlerkorrektur in x- und y-Richtung mittels Produktcode einer vorgebbaren Anzahl von zweidimensionalen Produktcodeblöcken Prüfsymbole in z-Richtung hinzugefügt werden. Die Prüfsymbole werden aus hintereinanderliegenden Daten- bzw. Prüfsymbolen der zweidimensionalen Produktcodeblöcke gewonnen. Auf diese Weise werden zusätzliche zweidimensionale Datenblöcke mit Korrekturdaten erzeugt. Die Anzahl der zusätzlich entstehenden Datenblöcke entspricht dabei der Anzahl der Prüfsymbole des Codes in z-Richtung.

Das erfindungsgemäße Verfahren bietet die Möglichkeit nach einer Korrektur einfacher Fehler durch den Korrekturcode in x- und in y-Richtung einen weiteren Korrekturcode in z-Richtung zu nutzen, der die Richtigkeit der Korrektur überprüft oder der die Fehler, die durch den zweidimensionalen Code nur erkannt, nicht aber korrigiert werden konnten, korrigiert. Bei entsprechender Auslegung des Codes in z-Richtung können auch nicht erkannte Fehler oder fehlerhaft korrigierte Blöcke des zweidimensionalen Blockes korrigiert werden.

Entsprechend einer vorteilhaften Ausgestaltung der Erfindung weist der zweidimensionale Block des dritten Codes die gleiche Dimension auf, wie die zweidimensionalen Produktcodeblöcke.
Eine derartige Dimensionierung hat den Vorteil, daß bei der Aufzeichnung der Produktcodeblöcke und der Korrekturcodeblöcke der z-Richtung der Synchronisationsrahmen nicht verändert werden muß.

Eine weitere vorteilhafte Ausgestaltung der Erfindung sieht vor, daß jeweils ein zweidimensionaler Produktcodeblock auf eine Schrägspur aufgezeichnet wird. Weiterhin wird vorgesehen, daß zwei oder mehrere Produktcodeblöcke bzw. Korrekturcodeblöcke auf eine Schrägspur aufgezeichnet werden.
Durch eine Dimensionierung, die es erlaubt, einen Codeblock oder ein ganzes Vielfaches eines Codeblockes auf eine Schrägspur aufzuzeichnen, wird ebenfalls der Vorteil der einfachen Synchronisierung genutzt.

Beim Lesen der aufgezeichneten Daten vom Magnetband sieht eine vorteilhafte Ausgestaltung der Erfindung vor, daß zunächst die Decodierung der zweidimensionalen Produktcodeblöcke mit der Fehlerkorrektur in x-Richtung und in y-Richtung erfolgt und anschließend die Decodierung in z-Richtung ausgeführt wird.
Auf diese Weise können zunächst die Korrekturmöglichkeiten der zweidimensionalen Prüfcodes ausgeführt werden, anschließend wird mit dem Prüfcode in z-Richtung korrigiert.

Für viele Anwendungsfälle ist es auch vorteilhaft einen dreidimensionalen Block abzuspeichern und mit der Decodierung in z-Richtung zu beginnen.

Im folgenden wird die Erfindung an Hand der Figuren 1 bis 4 näher erläutert, die Figuren 5 und 6 beschreiben den Stand der Technik und sind bereits in der Beschreibungseinleitung ausgeführt.
Es zeigen:

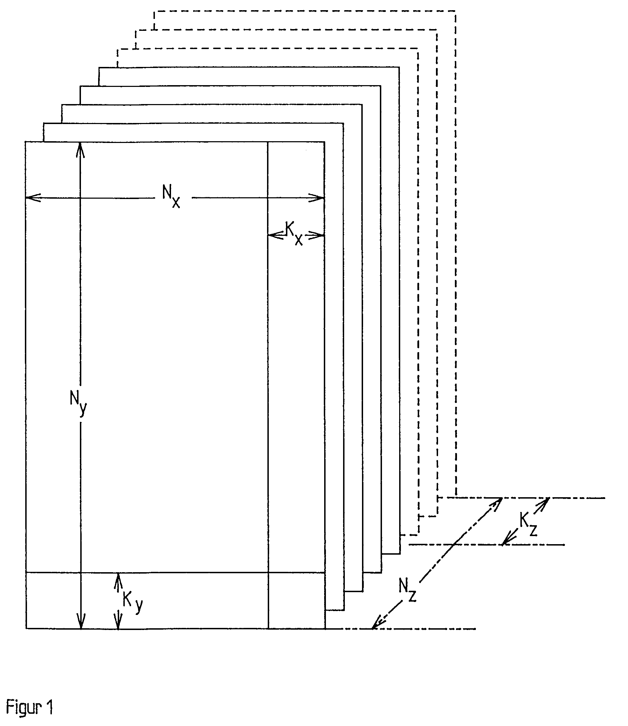

Figur 1 eine schematische Anordnung des dreidimensionalen Produktcodes,

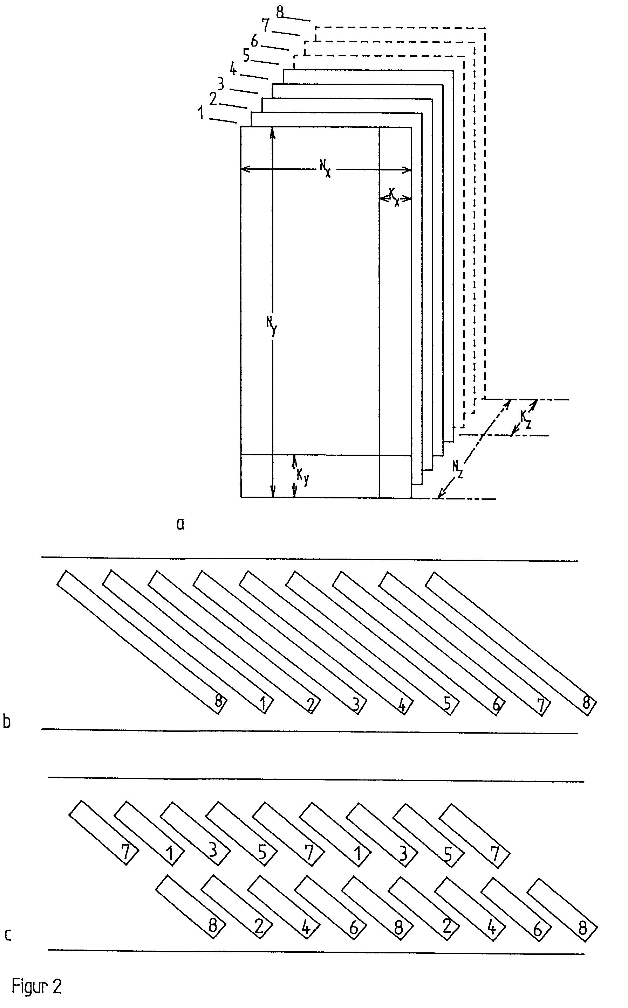

Figur 2 eine Anordnung des Produktcodes mit Aufzeichnungsbeispielen,

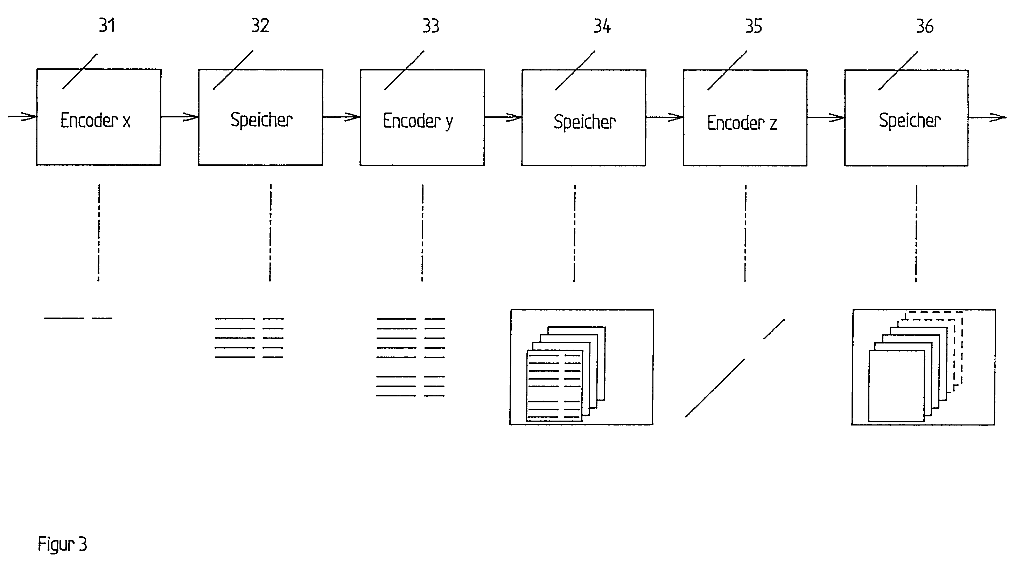

Figur 3 eine Anordnung zur Codierung nach dem erfindungsgemäßen Verfahren,

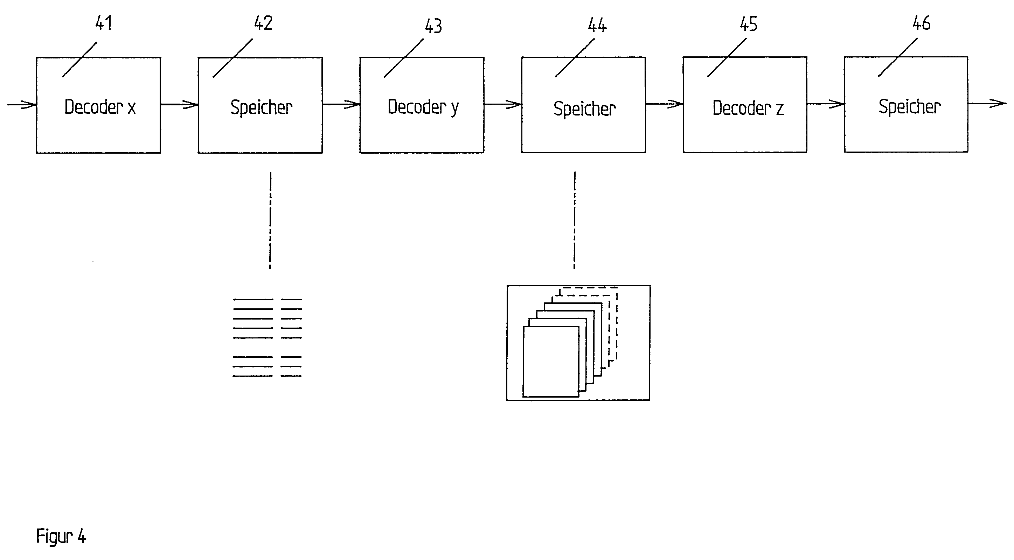

Figur 4 eine Anordnung zur Decodierung,
Figur 5 die Anordnung eines bekannten zweidimensionalen Produktcodes, und
Figur 6 ein Blockschaltbild einer bekannten Anordnung zur Erzeugung eines zweidimensionalen Produktcodes.

In Figur 1 ist der dreidimensionale Produktcode schematisch dargestellt. Der dreidimensionale Produktcode besteht aus mehreren, hintereinanderliegenden zweidimensionalen Produktcodeblöcken. Jeder zweidimensionale Produktcodeblock besteht aus einem Code in x-Richtung und einem Code in y-Richtung. Der Code wird gebildet, indem zunächst den Nutzdaten in x-Richtung nach jeder Zeile ein Prüfcode Kₓ hinzugefügt wird, der die für eine eventuell notwendige Korrektur oder Fehlererkennung benötigten Prüfdaten enthält. Ebenso wird den Nutzdaten in y-Richtung ein Prüfcode K_{y} hinzugefügt.
Insgesamt entstehen auf diese Weise zweidimensionale Produktcodeblöcke mit Nₓ Datenworten in x-Richtung und N_{y} Datenworten in y-Richtung.
Von den zweidimensionalen Produktcodeblöcken werden mehrere aufeinanderfolgende zusammengefaßt und mit einem Prüfcode K_{z} in z-Richtung versehen.
Auf diese Weise entstehen dreidimensionale Produktcodeblöcke, wie sie schematisch in Figur 1 dargestellt sind, wobei N_{z} die Datenwortlänge in z-Richtung ist.
Die Codierung in z-Richtung erfolgt so, daß jeweils bei der räumlichen Darstellung nach Figur 1 hintereinanderliegende Datenworte mit einem Prüfcode versehen werden.

Figur 2 zeigt zwei Möglichkeiten der Aufzeichnung von mit dreidimensionalem Produktcode versehenen Daten auf die Schrägspuren eines Magnetbandes.
Figur 2a zeigt eine schematische dreidimensionale Anordnung nach Figur 1, wobei hier den einzelnen zweidimensionalen Produktcodeblöcken Nummern zugeordnet sind, die mit der jeweiligen Numerierung in den Figuren 2b und 2c korrespondieren. Der dreidimensionale Produktcodeblock besteht aus fünf zweidimensionalen Produktcodeblöcken mit Nutzinformation sowie Prüfdaten in x- und y-Richtung und drei zweidimensionalen Produktcodeblöcken mit Prüfdaten der z-Richtung.
Die Figuren 2b und 2c zeigen zwei mögliche Aufzeichnungsformen auf die Schrägspuren eines Magnetbandes. In Figur 2b ist jeweils ein zweidimensionaler Produktcodeblock auf eine Spur aufgezeichnet. Zur Aufzeichnung des gesamten dreidimensionalen Produktcodeblockes werden acht Spuren benötigt. Jede Spur muß zusätzlich zu den Nutz- und Prüfdaten noch Synchronisationssymbole und Adressen enthalten, die in der Figur nicht dargestellt sind. Die Figur 2c zeigt ein Beispiel, bei dem auf jeder Aufzeichnungsspur zwei zweidimensionale Produktcodeblöcke aufgezeichnet werden.
Es ist außerdem denkbar einen zweidimensionalen Produktcodeblock in zwei oder mehrere Segmente aufzubrechen, so daß gegebenenfalls ein zweidimensionaler Produktcodeblock auf zwei oder mehrere Schrägspuren aufgezeichnet wird.

In Figur 3 ist ein Blockschaltbild zur Codierung des dreidimensionalen Produktcodes angegeben. In dieser Figur werden die Nutzdaten einem ersten Encoder 31 zugeführt. In diesem Encoder werden den einzelnen Zeilen von Nutzdaten Prüfdaten hinzugefügt und zeilenweise in den Speicher 32 eingeschrieben. Befindet sich eine genügende Anzahl von Zeilen im Speicher 32, wird dieser spaltenweise ausgelesen und die Daten an den Encoder 33 gegeben. Der Encoder 33 fügt jeder Spalte einen Prüfcode zu, so daß ein zweidimensionaler Produktcode entsteht. Die Nutz- und Prüfdaten werden in den Speicher 34 abgelegt. Der Speicher 34 ist so ausgelegt, daß er mehrere zweidimensionale Produktcodeblöcke faßt.
Aus dein Speicher 34 werden die Daten ausgelesen und dem Encoder 35 zugeführt, der Prüfsymbole in z-Richtung hinzufügt. Der Auslesevorgang aus dem Speicher 34 erfolgt dabei so, daß in z-Richtung hintereinanderliegende Datensymbole ausgelesen werden, die dann mit einem Prüfcode im Encoder 35 ergänzt werden.
Der vollständige dreidimensionale Produktcodeblock wird dann im Speicher 36 abgelegt, von dem aus die Daten für die Aufzeichnung auf das Magnetband ausgelesen werden.

Die Figur 4 beschreibt beispielhaft eine Wiedergabeanordnung für die nach Figur 3 aufgezeichneten Daten, wobei auf die Art der Fehlerkorrektur nicht eingegangen wird.
Die vom Magnetband gelesenen Daten werden zunächst einem Decoder 41 zugeführt, der eine Fehlererkennung bzw. Fehlerkorrektur mittels des Prüfcodes in x-Richtung vornimmt. Die erhaltenen Daten werden in den Speicher 42 abgelegt. Anschließend werden die Daten an den Decoder 43 gegeben, der eine Fehlererkennung bzw. Korrektur an Hand des Prüfcodes in y-Richtung vornimmt. Die daraus erhaltenen Daten werden in den Speicher 44 abgelegt. In diesem Speicher befinden sich nun die Daten, die vom zweidimensionalen Prüfcode befreit sind. In den Speicher 44 werden alle zweidimensionalen, durch den Prüfcode in x- und y-Richtung korrigierten bzw. gekennzeichneten fehlerbehafteten Daten abgelegt, die zu einem ursprünglich aufgezeichneten dreidimensionalen Produktcodeblock zusammengefasst waren. Diese Daten enthalten also mehrere zweidimensionale Blöcke, von denen eine bestimmte Anzahl aus Nutzdaten und eine weitere Anzahl aus Prüfdaten des Codes in z-Richtung bestehen. Aus dem Speicher werden die hintereinanderliegenden Symbole ausgelesen und an den Decoder 45 gegeben, von dem schließlich der Prüfcode in z-Richtung ausgewertet und die Nutzdaten entsprechend korrigiert werden. Die so erhaltenen Daten werden in den Speicher 46 abgelegt, von dem sie in der ursprünglich vorliegenden Reihenfolge der Nutzdaten wieder ausgelesen werden können.

Die Blockschaltbilder nach den Figuren 3 und 4 sind als mögliche Ausführungsformen zu verstehen, bei denen insbesondere die Reihenfolge der Codierung bzw. Decodierung verändert werden kann.

Durch die Auswertung des dreidimensionalen Codes können nun auch Fehler, die mit einem zweidimensionalen Code nur erkennbar waren, korrigiert werden. Bei geeigneten Fehlerkorrekturverfahren, wenn beispielsweise in z-Richtung mit Auslöschungskorrektur gearbeitet wird, können bei der Aufzeichnung mit vier Köpfen Daten, die durch einen defekten Kopf nicht aufgezeichnet wurden, wieder rekonstruiert werden.

## Patentansprüche

1. Verfahren zur Fehlerkorrektur bei der digitalen Magnetbandaufzeichnung und -Wiedergabe auf bzw. von Schrägspuren mittels Produktcode, wobei den Nutzdaten in x-Richtung und in y-Richtung Prüfsymbole hinzugefügt werden und die aufzuzeichnenden Daten in zweidimensionale Produktcodeblöcke zusammengefaßt werden
**dadurch gekennzeichnet,** daß
einer vorgebbaren Anzahl von zweidimensionalen Produktcodeblöcken in z-Richtung Prüfsymbole derart hinzugefügt werden, daß für alle hintereinander liegenden Symbole der zweidimensionalen Produktcodeblöcke ein dritter Code gebildet wird und dieser dritte Code aus mindestens einem zweidimensionalen Block besteht, und daß jeweils ein zweidimensionaler Produktcodeblock auf eine Schrägspur aufgezeichnet wird.

2. Verfahren nach Anspruch 1, **dadurch gekennzeichnet,** daß
der zweidimensionale Block des dritten Codes die Dimension der zweidimensionalen Produktcodeblöcke aufweist.

3. Verfahren nach Anspruch 1 oder 2, **dadurch gekennzeichnet,** daß mindestens zwei zweidimensionale Produktcodeblöcke auf eine Spur aufgezeichnet werden.

4. Verfahren nach einem oder mehreren der Ansprüche 1 bis 3, **dadurch gekennzeichnet,** daß bei der Wiedergabe der aufgezeichneten Daten zunächst eine Decodierung der zweidimensionalen Produktcodeblöcke mit entsprechender Fehlerkorrektur erfolgt und anschließend die Decodierung in z-Richtung erfolgt.

5. Verfahren nach einem oder mehreren der Ansprüche 1 bis 3, **dadurch gekennzeichnet,** daß bei der Wiedergabe der aufgezeichneten Daten zunächst in z-Richtung decodiert wird.

6. Anordnung zur Durchführung des Verfahrens nach einem oder mehreren der Ansprüche 1 bis 5 mit
- einem ersten Encoder (31), welcher den digitalen Eingangsdaten einen die Zeilen ergänzenden Prüfcode zufügt,
- einem Speicher (32), in den diese Daten zeilenweise eingelesen werden,
- einem zweiten Encoder (33), der die Daten aus dem Speicher (32) spaltenweise ausliest und jeder Spalte einen Prüfcode hinzufügt,
- einem zweiten Speicher (34), in den die zweidimensionalen Produktcodeblöcke eingeschrieben werden,
**gekennzeichnet durch**
- einen dritten Encoder (35), der den hintereinander liegenden Datenworten mehrerer zweidimensionaler Produktcodeblöcke einen Prüfcode hinzufügt, und
- einen dritten Speicher (36), in den die hintereinanderliegenden zweidimensionalen Produktcodeblöcke eingeschrieben werden, und von dem sie zur Aufzeichnung auf ein Magnetband der Reihe nach ausgelesen werden.

7. Anordnung zur Durchführung des Verfahrens nach einem oder mehreren der Ansprüche 1 bis 5 mit
- einem ersten Decoder (41) zur Decodierung der Daten und Auswertung einer ersten Dimension des zweidimensionalen Produktcodes
- einem ersten Speicher (42), in den die decodierten Daten eingeschrieben werden,
- einem zweiten Decoder (43) zur Decodierung der zweiten Dimension des zweidimensionalen Produktcodes, und
- einem zweiten Speicher (44), in den die Ausgangsdaten des zweiten Decoders (43) eingeschrieben werden
**gegennzeichnet durch**
- einen weiteren Decoder (45) zur Fehlerkorrektur der hintereinanderliegenden Datenworte mehrerer zweidimensionaler Produktcodeblöcke, und
- und einen dritten Speicher (46), in den die Daten nach der Fehlerkorrektur und zur weiteren Bearbeitung abgelegt werden.
